Europäisches Patentamt

European Patent Office

Office européen des brevets

(11) Publication number: **0 060 487**
**B1**

# EUROPEAN PATENT SPECIFICATION

(45) Date of publication of patent specification: **01.06.88**

(51) Int. Cl.⁴: **H 01 L 31/18, H 01 L 21/84**

(21) Application number: **82101832.2**

(22) Date of filing: **08.03.82**

(54) **Plugged pinhole thin film and method of making same.**

(30) Priority: **16.03.81 US 244151**

(43) Date of publication of application:
**22.09.82 Bulletin 82/38**

(45) Publication of the grant of the patent:
**01.06.88 Bulletin 88/22**

(84) Designated Contracting States:
**BE DE FR GB IT NL**

(56) References cited:
**AU-A-6 074 665**
**CA-A-1 077 161**
**DE-A-2 503 171**
**GB-A-1 488 307**
**US-A-4 185 294**

(73) Proprietor: **Sohio Commercial Development Co.**
**Midland Building**
**Cleveland Ohio 44115 (US)**

(73) Proprietor: **BP Photovoltaics Ltd.**
**Britannic House Moor Lane**
**London (GB)**

(72) Inventor: **Basol, Bulent M.**
**3444 Greenwood Avenue**
**Los Angeles California (US)**

(74) Representative: **Madgwick, Paul Roland et al**
**Ladas & Parry Isartorplatz 5**
**D-8000 München 2 (DE)**

Courier Press, Leamington Spa, England.

## Description

Background of the Invention

This invention relates to a plugged pinhole thin film photovoltaic device and a method of making the same thin film. As described in the "Handbook Of Thin Film Technology" edited by Leon I. Maissel and Reinhard Glang, McGraw-Hill Book Company (1970), pinholes occur in thin films due to a variety of causes. The most dreaded result of pinholes occurs when the film is an insulating or semiconductor film or an active element which becomes electrically shorted because of the pinholes.

To date there has been no known method of plugging such pinholes after they are formed in the thin film. Consequently the prior art approach to the pinhole problem has involved trying to avoid pinholes as much as possible. One method of avoidance has been to pay scrupulous attention to the process cleanliness and to material purities in the hope that the resulting film would be pinhole-free or substantially pinhole-free. Needless to say such approach necessarily involves a balancing between the expenses and efforts incurred in the thin film process to avoid pinholes against the number and size of the pinholes resulting. Another approach to avoiding pinholes is to increase the thickness of the film so that most pinholes are covered over. However, such approach necessarily involves excessive material costs and incurs undesirable effects in device applications where a very thin film is necessary.

The dreaded effect of pinholes becomes more acute as the size of devices increase, and thus has been especially acute for large sized photovoltaic and photoconductive devices.

In response to such pinhole problems and the relatively unsatisfactory methods of avoiding the pinhole problem which have been utilized in the past, an object of the present invention is a thin film photovoltaic device wherein the pinholes are plugged with an insulating material.

It is known from document AU—A—60746/65 to plug the pores in a sintered granular layer in a photoconductive cell with a photoresist. The document discloses a sintered layer of a semiconductor material formed on a glass substrate coated with an optically transparent conductive electrode material. Before application of a top electrode to the sintered material the cavities between the grains of the sintered material are filled with a photoresist and the whole device is exposed to light from the underside of the glass substrate. This hardens the photoresist where it lies in pores between the grains of the material. Where the photoresist is obscured by the grains of material, the photoresist does not harden and can be easily removed. A second electrode is then formed on the surface of the sintered material. While this document addresses the problem of plugging the pores of the sintered device, it does not address the problem of plugging pinholes in an electrodeposited layer of a thin film photovoltaic device.

Summary of the Invention

According to a first aspect the present invention provides a method of forming a photovoltaic device having a plurality of layers of conductive and semiconductive materials comprising the steps of: utilizing an electrically conductive, optically transparent substrate as an electrode; depositing electrochemically on said substrate at least one thin film of at least one semiconductor compound from an electrolytic bath including the components of said at least one semiconductor compound; coating the exposed surface of said at least one thin film with a layer of insulating photoresist material so that said photoresist material fills at least a substantial portion of substantially all of any pinholes in said thin film, the thin film being substantially opaque to the light wave length range that causes said photoresist material to become insoluble; transmitting light through said substrate so as to expose the uncoated side of said at least one thin film to light including the wave length range that causes said photoresist material to become insoluble so as to make said photoresist material in said pinholes insoluble thereby plugging the said pinholes; dissolving the uncured portions of said insulating photoresist material so as to remove said material from the surface of said at least one thin film; and depositing a back electrode on the surface of said thin film and said plugged pinholes.

According to a second aspect the present invention provides a photovoltaic device having a plurality of layers of conductive and semiconductive materials including an electrically conductive optically transparent substrate; an electrochemically deposited thin film of at least one semiconductor compound, the thin film being substantially opaque to light of a predetermined range of wave lengths, any pinholes in said thin film being plugged with an insulating photoresist material being cured by light of a wavelength of said predetermined range of wavelengths, and a back electrode on the surface of said thin film and said plugged pinholes.

Description of Drawings

Fig. 1 is a schematic cross sectional view of a portion of a thin film photovoltaic device made in accordance with current methods prior to the step of depositing thereon a back electrode.

Fig. 2 is a schematic cross sectional view of a portion of a thin film photovoltaic device made in accordance with current methods including the final step of depositing a back electrode.

Fig. 3 shows the device of Fig. 1 after the step of coating the one side with a layer of insulating photoresist material and the step of exposing the other side of said device to light in the light wavelength range which causes said photoresist material to become insoluble have both been carried out.

Fig. 4 shows the device of Fig. 3 after the unexposed photoresist material has been removed from the one side of the device.

Fig. 5 shows the device of Fig. 4 after a back electrode has been deposited and corresponds to the device of Fig. 2 after the method of the present invention has been incorporated in the method of making the device.

Fig. 6 is a graph of typical current-voltage curves for thin film photovoltaic devices made both as shown in Fig. 2 and Fig. 5.

Description of the Preferred Embodiment
of the Present Invention

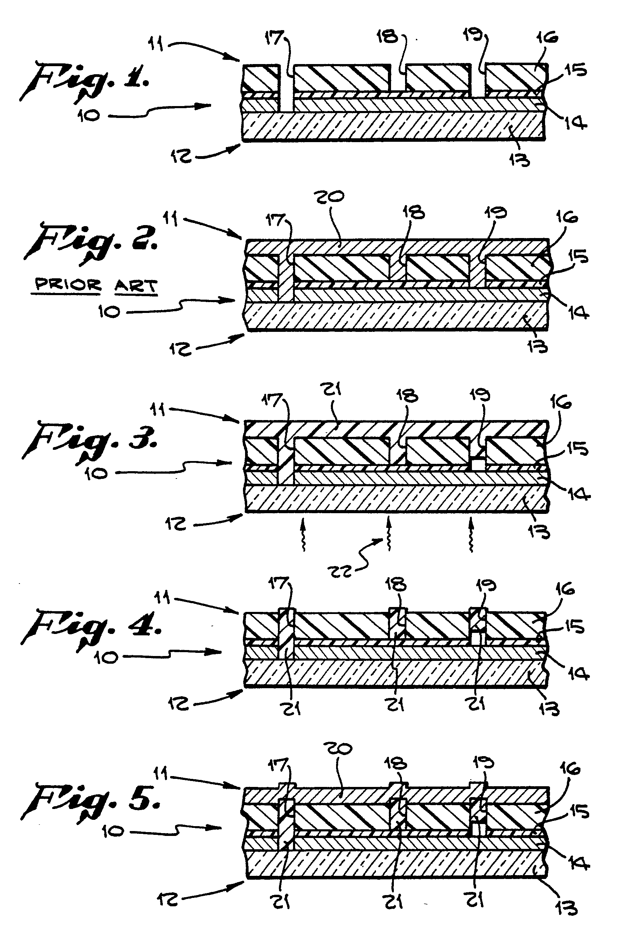

The photovoltaic device of the present invention and the method of making the same can best be described by reference to a thin film photovoltaic device wherein the presence of pinholes can effectively prevent the device from operating. Except for the step of the electrodeposition of cadmium sulfide (described below), the method of making the photovoltaic device illustrated in Fig. 1 is described in detail in CA—A—1,077,161 of Monosolar, Inc., entitled "PHOTO-VOLTAIC POWER GENERATING MEANS AND METHODS". For purposes of the present patent specification, it is sufficient to note that in Fig. 1 the device 10 includes a thin film 11 which is deposited on a substrate 12. The substrate 12 is composed of a sheet 13 of glass on which is deposited a layer 14 of indium tin oxide by well known techniques. The thin film 11 includes a first layer 15 of cadmium sulfide which is electrodeposited using the same equipment and generally the same process as described in the aforementioned patent, except a single carbon anode was used. The solution used was 0.2M $CdCl_2$ and 0.01M $Na_2S_2O_3$ with a pH of 4.5. The solution was stirred and heated to 90°C. The deposition voltage was −0.690V with reference to a calomel electrode. A second layer 16 of cadmium telluride is then electrodeposited as described above. For illustrative purposes there is shown in Fig. 1 a number of pinholes 17, 18, and 19 which extend to various depths through the film 11. Thus, pinhole 17 extends from the surface of the cadmium telluride layer 16 through to the glass sheet 13. Pinhole 18 extends from the surface of the cadmium telluride layer 16 to the cadmium sulfide layer 15. Pinhole 19 extends from the surface of the cadmium telluride layer 16 to the indium tin oxide layer 14.

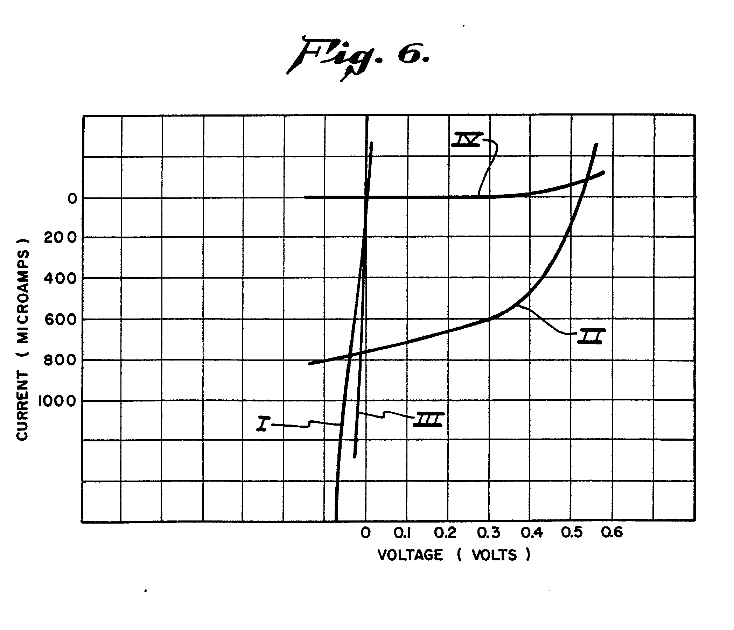

As shown in Fig. 2, the deposition of the gold layer 20 for a back electrode by the well known vacuum evaporation process also causes deposition of the gold in the pinholes 17, 18 and 19. Consequently, there are conductive paths from the gold surface to the indium tin oxide surface in the case of pinholes 17 and 19. Such conductive paths cause a shunting effect that at least degrades the effectiveness of the device and may, depending on the size and location, substantially prevent effective operation by short-circuiting the device.

· As set forth in Fig. 3, the film 11 and the substrate 12 are composed of the same set of layers and contain the illustrative pinholes 17, 18 and 19. However, prior to depositing the gold layer 20, the one side of thin film 11 is coated with a layer 21 of insulating photoresist material so that the photoresist material fills at least a substantial portion of substantially all of the pinholes in the thin film 11. Such thin film formed by the layers of cadmium sulfide 15 and cadmium telluride 16 is substantially opaque to the light wavelength range which causes such photoresist material to become insoluble. The opposite side of the substrate 12 is then exposed to light 22 in a wavelength range which causes said photoresist material to become insoluble. Such light travels through the glass sheet 13 and the indium tin oxide layer 14 and thus enters the back side of the film 11 so as to cause the photoresist material in the pinholes 17 and 19 to become insoluble. In the specific example shown in Fig. 3, the cadmium sulfide layer is sufficiently thin and thus transparent so as to cause the photoresist material in pinhole 18 also to become insoluble.

As shown in Fig. 4, the unexposed photoresist material 21 on the surface of the thin film 11 is then removed leaving the exposed insoluble photoresist material plugs in the pinholes 17, 18 and 19.

Finally, as illustrated in Fig. 5, the layer of gold is deposited in the same fashion as illustrated in Fig. 2. However, as also illustrated in Fig. 5, because of the plugs in pinholes 17, 18 and 19, the gold layer 20 no longer contacts the indium tin oxide conductive layer 14 on the back side of film 11. As illustrated in Fig. 5, it is not necessary for the pinhole plugging to be complete as shown in pinhole 19 wherein the photoresist material only partially fills such hole. Such partial plug should be sufficient to prevent the electrical contact between the gold layer 20 and the indium tin oxide layer 14.

A specific example of the comparison of the I—V characteristics of devices resulting from the above prior art procedure shown in Fig. 2 and the procedure of the present invention shown in Figs. 3—5 is illustrated in Fig. 6. In Fig. 6, curve I is the I—V plot of devices made by the prior art procedure and curve II is the same for devices made by the procedure of the present invention except as noted below. Such devices were produced by applying pinhole plugging to only one half of the area of a photovoltaic device as illustrated in Fig. 1 measuring approximately 2.5 × 3.4 cm (1" × 1-1/3") in size. The plugging process was generally in accordance with the procedures set forth in the application bulletin of the Eastman Kodak Company No. T-306 entitled "KODAK MICRORESIST 747" published in 1975. Consequently the treated and untreated areas were made the same way and only the treated area was subjected to the pinhole plugging so as to compare the results of the present invention with the conventional processing technique. Such treated area was coated with a thin film of the Kodak Microresist 747 liquid and then was spun at 5,000 rpm for approximately 20 seconds to provide a uniform thin coat of about 0.5 micrometer thickness. After spinning, the resist-coated photovoltaic device was baked in an oven for 15 minutes at a temperature of 80°C. After baking, the film area was exposed to a 200 watt high pressure mercury vapor lamp from the glass side. The photoresist layer was then developed in Kodak Microresist Developer by Immersion for 60 sec following which it was immersed in Kodak Microresist Rinse for 20 sec to strip away the uncured resist leaving only the cured resist plugs in the pinholes. It was then washed in double distilled water and dried in a jet of pure nitrogen. Next, the film was baked at 85° for 15 minutes. As would be expected in any photographic process, the steps of coating with photoresist and a subsequent development were done under dark room conditions with room illumination being provided by a gold fluorescent safe light lamp. The resist is kept in a dark bottle and handled like any photographic emulsion.

Next on both the treated and untreated areas, a series of five circular gold back electrode spots 0.2 cm² in area each were deposited by vacuum evaporation. The resulting solar cells were then tested for I—V characteristics. For light I—V measurements the cells were illuminated through the glass side by a lamp, i.e., General Electric EFR, 150W, 15V Quartz Halogen simulating AMI solar radiation, and the resulting curves were plotted as shown in Fig. 6 wherein curves I and III are the typical light I—V curves of all of the five spots in the untreated area and curve II is typical for four of the five spots in the treated area. The remaining spot in the treated area gave a curve similar to curves I and III and it is believed that it was shorted out due to causes unrelated to the process of the present invention. Curve IV is the typical dark I—V curve for the spots in the treated areas. As is obvious from a comparison of curve I with curve II, the process of the present invention is a very effective process for plugging pinholes in thin film photovoltaic devices which otherwise would normally short out such devices.

## Claims

1. A method of forming a photovoltaic device (10) having a plurality of layers of conductive and semiconductive materials, said method comprising the steps of:

utilizing an electrically conductive, optically transparent substrate (12) as an electrode;

depositing electrochemically on said substrate (12) at least one thin film (16, 15) of at least one semiconductor compound from an electrolytic bath including the components of said at least one semiconductor compound;

coating the exposed surface of said at least one thin film with a layer of insulating photoresist material (21) so that said photoresist material fills at least a substantial portion of substantially all of any pinholes (17, 18, 19) in said thin film, the thin film being substantially opaque to the light wave length range that causes said photoresist material to become insoluble;

transmitting light through said substrate so as to expose the uncoated side of said at least one thin film (16, 15) to light including the wave length range that causes said photoresist material (21) to become insoluble so as to make said photoresist material (21) in said pinholes (17, 18, 19) insoluble, thereby plugging the said pinholes (17, 18, 19);

dissolving the uncured portions of said insulating photoresist material (21) so as to remove said material from the surface of said at least one thin film; and depositing a back electrode (20) on the surface of said thin film and said plugged pinholes.

2. A method according to claim 1, wherein said thin film is selected from the group consisting of cadmium sulfide and cadmium telluride.

3. A method of claim 2, further including the step of depositing an electrically conductive, optically transparent film (14) on an electrically non-conductive, optically transparent substrate (13) to form the electrically conductive electrode (12).

4. A photovoltaic device (10) having a plurality of layers of conductive and semiconductive materials including an electrically conductive optically transparent substrate (12); an electrochemically deposited thin film (16, 15) of at least one semiconductor compound, the thin film being substantially opaque to light of a predetermined range of wavelengths, any pinholes (17, 18, 19) in said thin film being plugged with an insulating photoresist material being cured by light of a wavelength of said predetermined range of wavelengths, and a back electrode (20) on the surface of said thin film and said plugged pinholes (17, 18, 19).

5. A device according to claim 4, wherein said thin film includes a layer of either cadmium sulfide or cadmium telluride.

6. A device according to claim 4 or 5 wherein the electrically conductive substrate (12) comprises an electrically conductive optically transparent film (14) deposited on the surface of an electrically non-conductive optically transparent substrate (13).

## Patentansprüche

1. Verfahren zum Herstellen eines Photoelements mit einer Mehrzahl von Schichten aus leitenden und halbleitenden Werkstoffen, mit folgenden Schritten:

Als Elektrode wird ein elektrisch leitendes, optisch durchlässiges Substrats (12) verwendet;

auf dem Substrat (12) wird elektrochemisch mindestens eine dünne Schicht (16, 15) aus mindestens einer Halbleiterverbindung aus einem elektrolytischen Bad aufgetragen, das die Bestandteile der mindestens einen Halbleiterverbindung enthält;

die freiliegende Fläche der mindestens einen dünnen Schicht wird mit einer Schicht aus einem isolierenden Photolack (21) übertragen, der mindestens einen beträchtlichen Teil im wesentlichen aller Feinlunker (17, 18, 19) in der dünnen Schicht ausfüllt, die im wesentlichen opak ist für den Lichtwellenlängenbereich der den Photolack unlöslich machen würde;

durch Übertragung von Licht durch das Sub-

strat wird die unbeschichtete Seite der mindestens einen dünnen Schicht (16, 15) mit Licht belichtet, das Licht in dem Wellenlängenbereich enthält, der den Photolack (21) unlöslich macht, so daß der Photolack (21) in den Feinlunkern (17, 18, 19) unlöslich wird und die Feinlunker (17, 18, 19) zugestopft werden;

durch Auflösen der ungehärteten Teile des isolierenden Photolackes (21) wird dieser von der Oberfläche der mindestens einen dünnen Schicht entfernt; und auf die Oberfläche der dünnen Schicht und der zugestopften Feinlunker wird eine Gegenelektrode (16) aufgetragen.

2. Verfahren nach Anspruch 1, dadurch gekennzeichnet, daß die dünne Schicht aus der Gruppe ausgewählt ist, die aus dem Cadmiumsulfid und dem Cadmiumtellurid besteht.

3. Verfahren nach Anspruch 2, dadurch gekennzeichnet, daß zur Bildung der elektrisch leitenden Elektrode (12) auf eine elektrisch nichtleitendes, optisch durchsichtiges Substrat eine elektrisch leitende, optisch durchsichtige Schicht aufgetragen wird.

4. Photoelement mit einer Mehrzahl von Schichten aus leitenden und halbleitenden Werkstoffen einschließlich eines elektrisch leitenden, optisch durchsichtigen Substrats (12), einer elektrochemisch aufgetragenen dünnen Schicht (16, 15), die aus mindestens einer Halbleiterverbindung besteht und für Licht in einem vorherbestimmten Wellenlängenbereich im wesentlichen opak ist, wobei in der dünnen Schicht etwa vorhandene Feinlunker mit einem Photolack zugestopft sind, der durch die Einwirkung von Licht in einer Wellenlänge in dem vorherbestimmten Wellenlängenbereich härtbar ist, und einer auf der Oberfläche der dünnen Schicht und der zugestopften Feinlunker (17, 18, 19) angeordneten Gegenelektrode (16).

5. Photoelement nach Anspruch 4, dadurch gekennzeichnet, daß die dünne Schicht eine Schicht aus Cadmiumsulfid oder Cadmiumtellurid umfaßt.

6. Photoelement nach Anspruch 4 oder 5, dadurch gekennzeichnet, daß das elektrisch leitende Substrat eine elektrisch leitende, optisch durchsichtige Schicht umfaßt, die auf der Oberfläche eines elektrisch nichtleitenden, optisch durchsichtigen Substrats abgelagert ist.

**Revendications**

1. Procédé de formation d'un dispositif photovoltaïque possédant une pluralité de couches de matériaux conducteurs et semiconducteurs, comprenant les opérations suivantes:

utiliser un substrat optiquement transparent électriquement conducteur (12) comme électrode;

déposer électrochimiquement sur ledit substrat (12) au moins une pellicule mince (16, 15) d'au moins un composé semiconducteur à partir d'un bain électrolytique contenant les composants dudit ou desdits composés semiconducteurs;

revêtir la surface exposée de ladite ou desdites pellicules minces avec une couche d'un matériau photosensible, du type réserve, isolant (21) de façon que ledit matériau photosensible remplisse au moins une partie notable de sensiblement tous les trous d'épingle (17, 18, 19) existant dans ladite pellicule mince, la pellicule mince étant sensiblement opaque pour l'intervalle de longueur d'onde de la lumière qui amènerait ledit matériau photosensible à devenir insoluble;

transmettre de la lumière au travers dudit substrat afin d'exposer le côté non revêtu de ladite ou desdites pellicules minces (16, 15) à une lumière contenant l'intervalle de longueurs d'onde qui amènerait ledit matériau photosensible (21) à devenir insoluble afin de rendre insoluble ledit matériau photosensible (21) se trouvant dans lesdits trous d'épingle (17, 18, 19), si bien que l'on colmate lesdits trous d'épingle (17, 18, 19);

dissoudre les parties non durcies dudit matériau photosensible isolant (21) de manière à retirer ledit matériau de la surface de ladite ou desdites pellicules minces; et déposer une contre-électrode (16) sur la surface de ladite pellicule mince et desdits trous d'épingle obturés.

2. Procédé selon la revendication 1, où ladite pellicule mince est choisie dans le groupe comprenant le sulfure de cadmium et le tellurure de cadmium.

3. Procédé selon la revendication 2, comportant en outre l'opération qui consiste à déposer une pellicule optiquement transparente électriquement conductrice sur un substrat optiquement transpérent électriquement non conducteur afin de former l'électrode électriquement conductrice (12).

4. Dispositif photovoltaïque possédant une pluralité de couches de matériaux conducteurs et semiconducteurs, comportant un substrat optiquement transparent électriquement conducteur (12); une pellicule mince déposée électrochimiquement (16, 15) d'au moins un composé semi-conducteur, la pellicule mince étant sensiblement opaque à la lumière pour un intervalle prédéterminé de longueurs d'onde, tous les trous d'épingle se trouvant dans ladite pellicule mince étant colmatés avec un matériau photosensible du type réserve qui devient dur sous l'action de la lumière d'une longueur d'onde appartenant audit intervalle prédéterminée de longueurs d'onde, et une contre-électrode (16) placée sur la surface de ladite pellicule mince et desdits trous d'épingle colmatés (17, 18, 19).

5. Dispositif selon la revendication 4, où ladite pellicule mince comporte une couche de sulfure de cadmium ou bien de tellurure de cadmium.

6. Dispositif selon la revendication 4 ou 5, où le substrat électriquement conducteur comprend une pellicule optiquement transparente électriquement conductrice disposée sur la surface d'un substrat optiquement transparent électriquement non conducteur.

*Fig. 1.*

*Fig. 2.*

PRIOR ART

*Fig. 3.*

*Fig. 4.*

*Fig. 5.*

# Fig. 6.